# DEMANDE DE BREVET EUROPEEN

(11) **EP 4 528 812 A1**
(43) Date de publication de la demande: **26.03.2025**
(21) Numéro de dépôt: 24187162.3
(22) Date de dépôt: 08.07.2024
(51) Int. Cl.: H01L 23/498, H01L 23/538, H01L 21/48, H05K 1/18

(54) **FILM D'INTERCONNEXION ET STRUCTURE ÉLECTRONIQUE COMPRENANT UN TEL FILM**

(30) Priorité: 10.07.2023 FR 2307378
(71) Demandeur: Commissariat à l'Energie Atomique et aux Energies Alternatives, 75015 Paris (FR)
(72) Inventeur: SOURIAU, Jean-Charles, 38054 GRENOBLE CEDEX 09 (FR); DE GIROLAMO, Julia, 38054 GRENOBLE CEDEX 09 (FR); DESPAX-FERRERES, Auriane, 38054 GRENOBLE CEDEX 09 (FR)
(74) Mandataire: Cabinet Camus Lebkiri

(57) **Abrégé**

Un aspect de l'invention concerne un film d'interconnexion (40) comprenant :
- une couche de base (41) en un matériau polymère isolant et comprenant une première face (41a) et une deuxième face (41b) ;
- une pluralité de premiers motifs (42) en saillie par rapport à la première face, formés du matériau polymère isolant et configurés pour que le film d'interconnexion constitue un film d'adhésif sec ;
- un élément métallique (43) en métal massif comprenant :
- un corps (431) qui s'étend à travers la couche de base ; et
- dans le prolongement du corps, au moins un deuxième motif (432) en saillie par rapport à la première face, présentant une forme différente de celle des premiers motifs et, dans un plan parallèle à la première face, une section constante ou décroissante en s'éloignant de la première face.

## Description

### DOMAINE TECHNIQUE

Le domaine technique de l'invention est celui des films pour interconnecter électriquement et mécaniquement deux objets, par exemple un composant électronique et un substrat flexible capable de se déformer et de s'adapter à une surface non plane telle que la peau. La présente invention concerne plus particulièrement un film d'interconnexion comprenant des motifs configurés pour former un film d'adhésif sec. La présente invention concerne également une structure électronique comprenant un substrat, un composant électronique et le film d'interconnexion disposé entre le substrat et le composant électronique.

### ÉTAT DE LA TECHNIQUE

Les structures électroniques souples peuvent intégrer des composants électroniques tels que des circuits intégrés, des capteurs, des actionneurs, des batteries, des composants passifs, des puces d'identification par radiofréquence (ou RFID, pour « radio frequency identification » en anglais) et des antennes. La fabrication d'une structure électronique souple comprend le report d'un ou plusieurs composants électroniques sur un substrat flexible, aussi appelé circuit imprimé flexible. Ce substrat comprend un film support, par exemple en polyester, polyimide, polytétrafluoroéthylène ou polyétheréthercétone, et des pistes métalliques disposées à la surface du film support. Chaque composant électronique comprend des plots de connexion qui débouchent sur une face du composant, cette face étant communément appelée « face active ».

Une première technique d'interconnexion (appelée « wire bonding » en anglais) consiste à relier électriquement les plots de connexion du composant aux pistes métalliques du substrat par des fils, lorsque la face active du composant est tournée vers le haut.

Lorsqu'au contraire la face active du composant est tournée vers le bas (autrement dit lorsqu'elle est disposée en regard du substrat), les plots de connexion du composant peuvent être connectés aux pistes métalliques du substrat par brasage, à l'aide d'un matériau fusible, d'une colle conductrice ou d'un élément conducteur pressé sur chaque plot d'interconnexion. Cette deuxième technique d'interconnexion, électrique et mécanique, est communément appelée « flip-chip », en référence à la position retournée du composant. Des éléments d'interconnexion, tels que des microbilles fusibles, un film conducteur anisotrope ou des bossages en or (plus connu sous le nom de « stud bump »), peuvent être disposés entre le composant et le substrat.

Comme les composants électroniques sont souvent épais et rigides, les contraintes en flexion dans la structure électronique sollicitent fortement les interfaces de collage, de soudure ou de brasure, qui finissent par rompre.

Pour remédier à ce problème, il a été proposé de placer les interfaces ou éléments d'interconnexion au plus près du plan neutre de la structure électronique.

Par exemple, le document US2006/097373A1 décrit une structure électronique comprenant un substrat flexible et un composant électronique collé au substrat au moyen d'une couche de résine thermodurcissable, typiquement une résine époxy. Un pilier conducteur relie électriquement un plot de connexion aménagé dans la face active du composant et une piste métallique disposée sur le substrat flexible. Ce pilier conducteur s'étend à travers la couche de résine thermodurcissable. La structure électronique comprend en outre une couche isolante dite de passivation, dont l'épaisseur est choisie pour amener le plan neutre de la structure au niveau de la face active du composant.

Cet agencement permet de limiter les contraintes mécaniques en flexion au niveau de la connexion électrique du composant (autrement dit lorsque la structure électronique est pliée). En revanche, il n'est pas totalement satisfaisant lorsque la structure électronique est soumise à des contraintes de traction (étirement) ou de cisaillement.

La figure 1 représente une structure électronique 1 décrite dans la demande de brevet FR3126259A1. La structure électronique 1 comprend un substrat 10, un composant électronique 20 et un film d'interconnexion 30 disposé entre le substrat 10 et le composant électronique 20. Le film d'interconnexion 30 relie électriquement et mécaniquement le composant électronique 20 au substrat 10. Cette structure électronique 1 est conçue pour présenter une durée de vie élevée, grâce notamment à une meilleure résistance aux contraintes de traction (étirement) et/ou de cisaillement.

Le film d'interconnexion 30 comprend une première face 30a, une deuxième face 30b opposée à la première face, une zone électriquement conductrice 31 s'étendant de la première face 30a à la deuxième face 30b et un matériau polymère 32 électriquement isolant enrobant la zone électriquement conductrice 31. Au moins l'une des première et deuxième faces 30a-30b du film d'interconnexion 30 est structurée de manière à former un film d'adhésif sec, en présentant une pluralité de motifs 33 en saillie. Les motifs 33 sont par exemple en forme de champignons. Une partie des motifs 33 sont formés du matériau polymère 32 et l'autre partie des motifs 33 appartiennent à la zone électriquement conductrice 31.

La zone électriquement conductrice 31 comprend un matériau électriquement conducteur, de préférence choisi parmi des nanofils de carbone, des nanotubes de carbone, du noir de carbone, des particules métalliques ou du graphène. Ce matériau électriquement conducteur peut être utilisé seul ou en mélange avec un matériau polymère, identique ou différent du matériau polymère formant la base du film d'interconnexion.

Le procédé de fabrication du film d'interconnexion 30 comprend la formation d'un moule comprenant des cavités, par exemple en forme de champignons, le dépôt d'un matériau conducteur (par exemple des nanotubes de carbone) dans une région du moule pour former la zone électriquement conductrice 31, l'enrobage de la zone électriquement conductrice 31 par le matériau polymère 32 et le démoulage du film d'interconnexion 30 ainsi obtenu.

### RÉSUMÉ DE L'INVENTION

L'invention a pour but d'améliorer les performances du film d'interconnexion de l'art antérieur sans pour autant rendre sa fabrication plus difficile.

Selon un premier aspect de l'invention, on tend vers cet objectif en prévoyant un film d'interconnexion comprenant :
- une couche de base formée d'un matériau polymère électriquement isolant et comprenant une première face et une deuxième face opposée à la première face ;
- une pluralité de premiers motifs en saillie par rapport à la première face, les premiers motifs étant formés du matériau polymère électriquement isolant et configurés pour que le film d'interconnexion constitue un film d'adhésif sec ;
- un élément métallique comprenant :
   - un corps qui s'étend à travers la couche de base, de la première face à la deuxième face ; et
   - dans le prolongement du corps, au moins un deuxième motif en saillie par rapport à la première face.

Le film d'interconnexion est remarquable en ce que l'élément métallique est en métal massif et en ce que ledit au moins un deuxième motif de l'élément métallique présente une forme différente de celle des premiers motifs et, dans un plan parallèle à la première face, une section constante ou décroissante en s'éloignant de la première face.

Ainsi, l'élément métallique présente une conductivité électrique et une rigidité plus élevées que la zone électriquement conductrice du film d'interconnexion selon l'art antérieur. La forme du deuxième motif de l'élément métallique, différente de celle des premiers motifs, permet de continuer à utiliser un moule pour fabriquer le film d'interconnexion. En effet, le deuxième motif de l'élément métallique ne risque pas de casser lors du démoulage et de rester prisonnier du moule. Le film d'interconnexion peut donc être fabriqué facilement et en grand volume.

De préférence, chaque premier motif comprend un pilier qui s'étend depuis la première face de la couche de base et un chapeau situé à une extrémité du pilier, le chapeau ayant, dans un plan parallèle à la première face, des dimensions supérieures à celles du pilier.

Avantageusement, l'élément métallique comprend en outre, dans le prolongement du corps, une tête qui repose sur la deuxième face de la couche de base.

Ledit au moins un deuxième motif de l'élément métallique peut présenter une hauteur supérieure ou égale à celle des premiers motifs.

Un deuxième aspect de l'invention concerne une structure électronique comprenant :
- un substrat ;
- un composant électronique ;
- un film d'interconnexion selon le premier aspect de l'invention, disposé entre le substrat et le composant électronique de manière à relier électriquement et mécaniquement le composant électronique au substrat.

De préférence, le substrat comprend un plot électriquement conducteur, le composant électronique comprend un plot de connexion et l'élément métallique du film d'interconnexion relie le plot électriquement conducteur au plot de connexion.

Dans un mode de réalisation préférentiel, la première face de la couche de base est disposée en regard du substrat, les premiers motifs sont en contact avec le substrat et la deuxième face de la couche de base est disposée en regard du composant électronique.

Selon un développement de ce mode de réalisation préférentiel, la deuxième face de la couche de base est séparée du composant électronique par une couche de colle.

Un troisième aspect de l'invention concerne un procédé de fabrication d'un film d'interconnexion, comprenant les étapes suivantes :
- fournir un moule comprenant des premières cavités et une deuxième cavité, les premières cavités et la deuxième cavité s'étendant depuis une face extérieure du moule, la deuxième cavité ayant une forme différente de celle des premières cavités et, dans un plan parallèle à la face extérieure, une section constante ou décroissante en s'éloignant de la face extérieure ;
- former un élément métallique dans une région du moule comprenant la deuxième cavité, l'élément métallique comprenant un corps disposé sur la face extérieure du moule et, dans le prolongement du corps, un motif en saillie disposé à l'intérieur de la deuxième cavité ;
- déposer un matériau polymère électriquement isolant dans les premières cavités et sur la face extérieure du moule, de manière à former un film de polymère qui enrobe le corps de l'élément métallique ; et
- démouler le film de polymère et l'élément métallique.

De préférence, l'étape de formation de l'élément métallique comprend les sous-étapes suivantes :
- déposer une couche métallique de germination dans la deuxième cavité et sur la face extérieure du moule ;
- former un masque sur la couche métallique de germination, le masque comprenant un évidement qui expose ladite région du moule comprenant la deuxième cavité ;
- remplir la deuxième cavité du moule et l'évidement du masque d'un métal par croissance électrolytique depuis la couche de germination ; et
- retirer le masque et graver la couche métallique de germination.

L'étape de fourniture du moule peut comprendre les sous-étapes suivantes :
- fournir un empilement comprenant successivement une couche de support, une couche diélectrique et une couche mince ;
- former les premières cavités en gravant la couche mince jusqu'à la couche diélectrique, puis en gravant la couche diélectrique sélectivement par rapport à la couche mince et la couche de support ; et
- former la deuxième cavité en gravant au moins la couche mince et la couche diélectrique.

Alternativement, l'étape de fourniture du moule peut comprendre les sous-étapes suivantes :
- fournir un empilement comprenant successivement une couche de support, une couche diélectrique et une couche mince ;
- former les premières cavités en gravant de manière anisotrope la couche mince jusqu'à la couche diélectrique, puis en effectuant une sur-gravure de la couche mince ; et
- former la deuxième cavité en gravant au moins la couche mince jusqu'à la couche diélectrique.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures suivantes :
- la figure 1, précédemment décrite, représente une structure électronique comprenant un film d'interconnexion selon l'art antérieur ;
- la figure 2 représente schématiquement un premier mode de réalisation du film d'interconnexion selon le premier aspect de l'invention ;
- la figure 3 représente schématiquement un deuxième mode de réalisation du film d'interconnexion ;
- la figure 4 représente schématiquement un troisième mode de réalisation du film d'interconnexion ;
- la figure 5 représente schématiquement un mode de réalisation préférentiel d'une structure électronique selon le deuxième aspect de l'invention, la structure électronique comprenant un substrat, un composant électronique et le film d'interconnexion disposé entre le substrat et le composant électronique ;
- la figure 6 représente schématiquement le contact entre un élément métallique du film d'interconnexion et un plot conducteur du substrat ;
- les figures 7A à 7K représentent des étapes d'un procédé de fabrication de film d'interconnexion selon le troisième aspect de l'invention ; et
- la figure 8 représente une étape du procédé de fabrication pouvant remplacer les étapes des figures 7B et 7C.

Pour plus de clarté, les éléments identiques ou similaires sont repérés par des signes de référence identiques sur l'ensemble des figures.

### DESCRIPTION DÉTAILLÉE

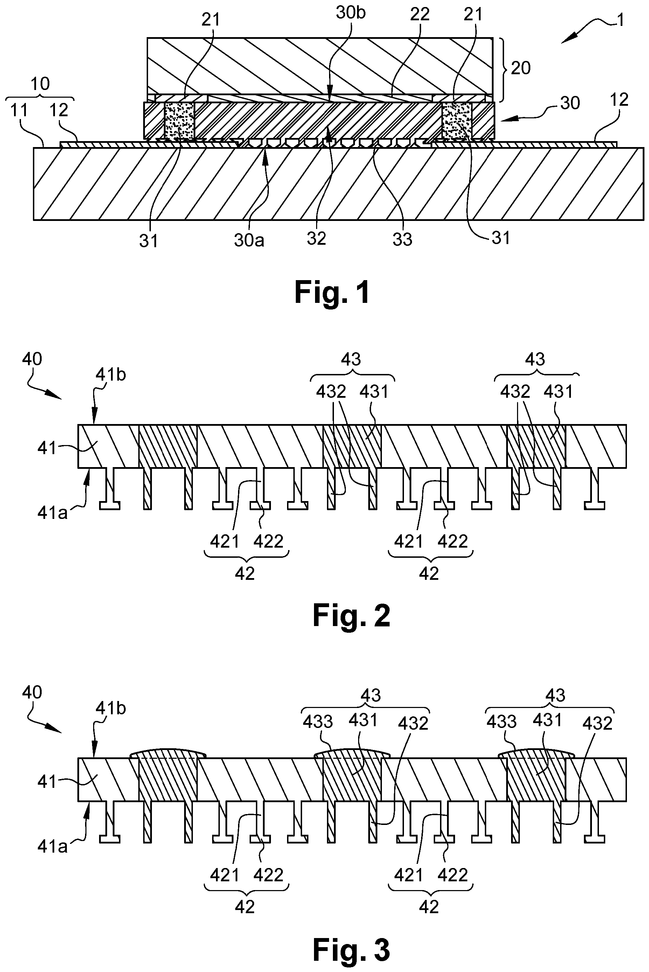

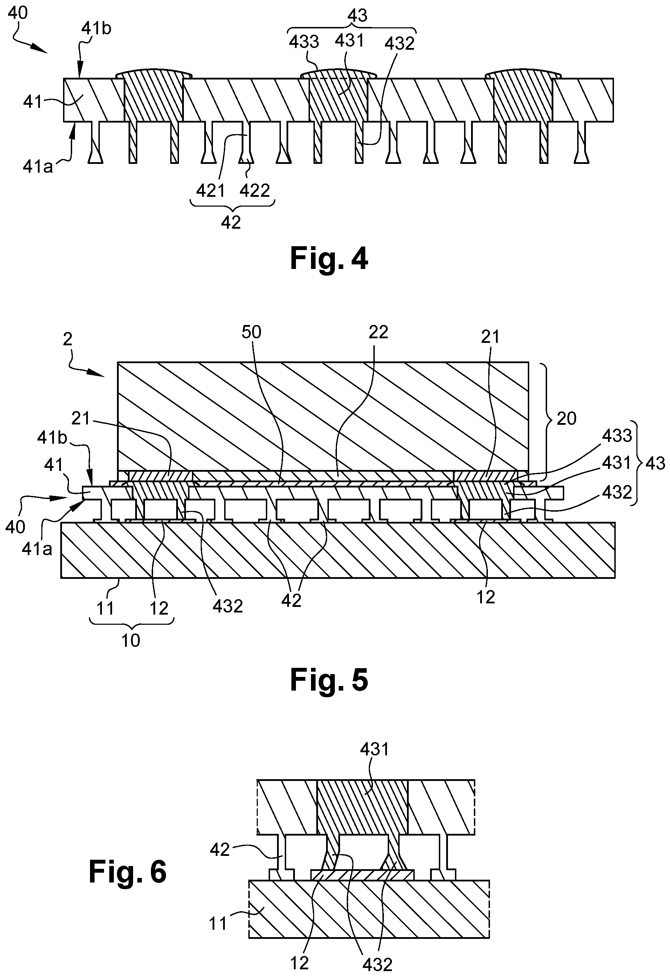

Les figures 2 à 4 représentent en vue de coupe schématique différents modes de réalisation d'un film d'interconnexion 40. Ce film d'interconnexion 40 peut notamment servir à relier mécaniquement et électriquement un composant électronique à un substrat, comme décrit ci-après en relation avec la figure 5.

D'une manière commune à tous ces modes de réalisation, le film d'interconnexion 40 comprend :
- une couche de base 41 formée d'un matériau polymère électriquement isolant, la couche de base 41 comprenant une première face 41a et une deuxième face 41b opposée à la première face 41a ;
- des premiers motifs 42 en saillie par rapport à la première face 41a, les premiers motifs 42 étant formés du même matériau polymère que la couche de base 41 ; et
- au moins un élément métallique 43 comprenant :
   - un corps 431 qui s'étend à travers la couche de base 41, de la première face 41a à la deuxième face 41b ; et
   - dans le prolongement du corps 431, au moins un deuxième motif 432 en saillie par rapport à la première face 41a.

Les première et deuxième faces 41a-41b de la couche de base 41 sont avantageusement planes et parallèles entre elles. L'épaisseur de la couche de base 41 (autrement dit la distance entre les première et deuxième faces 41a-41b) est par exemple comprise entre 10 µm et 250 µm, de préférence entre 50 µm et 200 µm.

Le matériau polymère électriquement isolant permet au film d'interconnexion 40 de s'étirer, de se comprimer et/ou de se tordre. Le film d'interconnexion 40 est donc un film flexible et/ou étirable. Un film, une couche ou un substrat est ici qualifié de « flexible » lorsqu'il ou elle peut subir, sans rompre, une flexion d'un rayon de courbure inférieur ou égal à 1000 mm. On entend par « film étirable » un film qui peut s'allonger sous sollicitation mécanique de plus de 5 %. De préférence, le matériau polymère représente plus de 50 % du volume total du film d'interconnexion 40. Le volume restant du film d'interconnexion 40 est avantageusement constitué par les éléments métalliques 43.

Le matériau polymère du film d'interconnexion 40 est de préférence un élastomère. Le matériau élastomère peut être un élastomère de silicone tel que le polydiméthylsiloxane (PDMS), un polyuréthane, un polyuréthane-acrylate, un polyvinylsiloxane, un polypropylène, l'acide polylactique-co-glycolique (PLGA) ou le silicone polyaddition (aussi appelé « platinum silicone »).

Les premiers motifs 42 ont une forme et des dimensions telles que le film d'interconnexion 40 constitue un film d'adhésif sec. L'adhésif sec, inspiré des pattes du gecko et dont le pouvoir d'adhésion repose sur des forces de Van der Waals, est obtenu grâce à une micro-structuration en surface d'un matériau (typiquement un matériau polymère). On dénommera ce type de film un « ruban gecko » (ou « gecko tape » en anglais). Ainsi, le film d'interconnexion 40 présente tout ou partie des propriétés d'un adhésif sec. Les propriétés d'un adhésif sec sont une adhérence directionnelle (ou anisotrope), une bonne fixation avec une précharge mécanique minimale, un détachement facile, un auto-nettoyage (absence de résidus laissés sur la surface) et une forte capacité de réutilisation.

Les adhésifs secs sont de bons adhésifs principalement dans le cas d'une sollicitation perpendiculaire (« pull-off ») ou latérale (cisaillement) mais moins bons dans le cas d'un pelage avec un angle de pelage élevé. Ce sont aussi des adhésifs respirants et souvent lavables (avantageux dans le cas d'une utilisation directe sur la peau).

Le film d'interconnexion 40 peut être aussi vu comme ayant deux faces opposées, une de ses faces étant structurée de manière à former un film d'adhésif sec.

Les premiers motifs 42 ont de préférence une forme et des dimensions identiques (aux tolérances de fabrication près).

Dans les modes de réalisation représentés par les figures 2 à 4, les premiers motifs 42 ont une forme de champignon. Ils sont alors semblables aux spatules présentes à l'extrémité des setae du gecko. Chaque premier motif 42 comprend un pilier 421 (formant le pied du champignon) et un chapeau 422. Le pilier 421 s'étend depuis la première face 41a, de préférence perpendiculairement à la première face 41a. Il comprend ainsi une première extrémité solidaire de la couche de base 41. Le chapeau 422 est situé à une deuxième extrémité opposée (c.-à-d. éloignée de la première face 41a) du pilier 421 et présente, dans un plan parallèle à la première face 41a, des dimensions supérieures à celles du pilier 421.

Le pilier 421 des premiers motifs 42 présente, dans un plan parallèle à la première face 41a, une section qui est avantageusement constante sur toute la hauteur du pilier (piliers de forme cylindrique, représentés sur les figures 2 à 4) ou décroissante en s'éloignant de la première face 41a (piliers de forme tronconique). Cette section est par exemple ronde, rectangulaire (carrée notamment) ou hexagonale.

Les dimensions de la section du pilier 421 (mesurées dans un repère orthonormé) sont avantageusement comprises entre 5 µm et 100 µm. La hauteur du pilier 421 (mesurée perpendiculairement à la première face 41a) peut être comprise entre 5 µm et 30 µm.

Le chapeau 422 des premiers motifs 42 présente (dans un plan parallèle à la première face 41a) une section dont les dimensions sont supérieures à celles du pilier 421. Cette section, de préférence ronde ou ovale, peut être constante sur toute la hauteur du chapeau ou croissante en s'éloignant de la deuxième extrémité du pilier 421, comme cela est représenté sur la figure 4. Les dimensions maximales du chapeau 422, à son sommet (c'est-à-dire à l'extrémité la plus éloignée de la première face 41a) sont de préférence égales aux dimensions du pilier 421 plus une valeur δ comprise entre 1 µm et 6 µm. Ainsi, on aura par exemple d2 = d1+δ dans le cas d'un pilier 421 de section ronde (diamètre d1) et d'un chapeau 422 de section ronde (diamètre d2) ou x2 = x1+δ et y2 = y1+δ dans le cas d'un pilier 4211 de section rectangulaire (dimensions x1, y1) et d'un chapeau 422 de section ovale (dimensions x2, y2). La hauteur du chapeau 422 est de préférence comprise entre 1 µm et 5 µm.

Dans une variante de réalisation non représentée par les figures, les premiers motifs 42 sont des piliers de section constante sur toute leur hauteur (piliers cylindriques) ou de section croissante en s'éloignant de la première face 41a (piliers tronconiques). La section des piliers est par exemple ronde, rectangulaire (carrée notamment) ou hexagonale. Les piliers s'étendent de préférence perpendiculairement à la première face 41a.

Comme décrit précédemment, le film d'interconnexion 40 comprend un ou plusieurs éléments métalliques 43 traversant la couche de base 41. A titre d'exemple, les figures 2 à 4 montrent trois éléments métalliques 43, chaque élément métallique 43 comprenant un corps 431 et une pluralité de deuxièmes motifs 432 (ici deux).

Chaque élément métallique 43 peut avoir pour but de réaliser une connexion électrique entre deux objets disposés de part et d'autre du film d'interconnexion 40. Les éléments métalliques 43 peuvent avoir des formes et des dimensions différentes (selon les objets à connecter). Le nombre N de deuxièmes motifs 432 par élément métallique peut également varier entre les éléments métalliques 43 (N est un entier naturel supérieur ou égal à 1).

Dans la suite de la description, on prendra l'exemple d'un film d'interconnexion 40 comprenant plusieurs éléments métalliques 43 avec plusieurs deuxièmes motifs 432 chacun. Cette description reste cependant valable dans le cas d'un unique élément métallique 43 (comprenant un ou plusieurs deuxièmes motifs 432) et dans le cas d'éléments métalliques comprenant chacun un seul deuxième motif 432.

Les éléments métalliques 43 sont en métal massif (ou métal plein), c'est-à-dire qu'ils sont constitués d'un ou plusieurs métaux et dépourvus d'interstices (à la différence d'un élément métallique constitué de particules métalliques agglomérées, par exemple). Les éléments métalliques 43 sont par exemple en cuivre, nickel, or, argent, aluminium ou en un alliage de ces métaux.

Les éléments métalliques 43 présentent ainsi une conductivité électrique élevée, largement supérieure à celle d'un élément métallique comprenant des particules conductrices mélangées à un matériau polymère.

Le corps 431 des éléments métalliques 43 est enrobé par le matériau polymère électriquement isolant de la couche de base 41. Le matériau polymère constitue ainsi une ou plusieurs zones électriquement isolantes qui séparent les éléments métalliques 43, aussi appelés inserts métalliques.

Le corps 431 présente, dans un plan parallèle à la première face 41a, une section qui est avantageusement constante sur toute sa hauteur (égale à l'épaisseur de la couche de base 41). Cette section est par exemple ronde, rectangulaire (carrée notamment) ou hexagonale. Les dimensions de la section du corps 431 (mesurées dans un repère orthonormé) sont avantageusement comprises entre 2 µm et 50 µm.

Les deuxièmes motifs 432 en métal ont une forme (et une fonction) différente de celle des premiers motifs 42 en polymère. Leur rôle est d'entrer en contact avec l'objet situé du côté de la première face 41a de la couche de base 41, afin de réaliser une connexion électrique. Ils ne participent pas (ou quasiment pas) à l'adhésion sèche du film d'interconnexion 40, contrairement aux premiers motifs 42.

Les deuxièmes motifs 432 ont de préférence une forme et des dimensions identiques (aux tolérances de fabrication près).

Les deuxièmes motifs 432 présentent, dans un plan parallèle à la première face 41a, une section constante ou décroissante en s'éloignant de la première face 41a. Cette géométrie permet aux deuxièmes motifs 432 d'être démoulés facilement, sans endommagement, malgré leur rigidité élevée (due au fait qu'ils sont en métal massif).

La section des deuxièmes motifs 432 est par exemple ronde, rectangulaire (carrée notamment) ou hexagonale. Ses dimensions (mesurées dans un repère orthonormé) sont avantageusement comprises entre 5 µm et 100 µm, de préférence entre 5 µm et 15 µm. La hauteur des deuxièmes motifs 432 peut être supérieure ou égale à la hauteur des premiers motifs 42.

Dans les modes de réalisation des figures 3 et 4, chaque élément métallique 43 comprend, outre le corps 431 et les deuxièmes motifs 432, une tête 433 dans le prolongement du corps 431. Cette tête 433, ou collerette, repose en partie sur la deuxième face 41b de la couche de base 41. Elle permet d'obtenir un meilleur contact électrique avec l'objet à connecter, situé du côté de la deuxième face 41b. En outre, elle améliore le maintien de l'élément métallique 43 dans la couche de base 41, en particulier lors de l'étape de démoulage du procédé de fabrication décrit ultérieurement.

La tête 433 présente, dans le plan de la deuxième face 41b, des dimensions supérieures à celles du corps 431. Les dimensions maximales de la tête 433, au niveau de la deuxième face 41b, sont de préférence égales aux dimensions du corps 431 plus une valeur δ' comprise entre 1 µm et 10 µm. Sa face intérieure, plane, repose sur la couche de base 41. Sa face extérieure peut être plane ou arrondie.

A l'inverse, dans le mode de réalisation de la figure 2, chaque élément métallique 43 est dépourvu de tête et ne comprend donc que le corps 431 et les deuxièmes motifs 432.

Les premiers motifs 42 en matériau polymère peuvent être répartis de manière régulière sur la première face 41a de la couche de base 41, afin d'obtenir une adhésion homogène du film d'interconnexion 40. Ils présentent alors un premier pas de répétition dans une première direction et un deuxième pas de répétition dans une deuxième direction différente de la première direction. Le deuxième pas de répétition peut être égal au premier pas de répétition.

L'ensemble des premiers motifs 42 présents sur la première face 41a constitue ainsi un réseau. Le réseau des premiers motifs 42 peut notamment être à maille rectangulaire (directions D1-D2 perpendiculaires), carrée (directions D1-D2 perpendiculaires et pas de répétition P1-P2 égaux) ou en forme de parallélogramme (angle entre les directions D1-D2 compris entre 0° et 90° exclus). Le réseau de premiers motifs 42 occupe avantageusement plus de 50 %, et de préférence plus de 90 %, de la superficie de la première face 41a.

Les deuxièmes motifs 432 des éléments métalliques 43 peuvent être intégrés au réseau des premiers motifs 42 (en respectant les premier et deuxième pas de répétition). Ils prennent alors la place de certains premiers motifs 42.

La figure 5 illustre un exemple d'utilisation du film d'interconnexion 40. Cette figure représente schématiquement une structure électronique 2 comprenant un substrat 10, un composant électronique 20 et le film d'interconnexion 40 disposé entre le substrat 10 et le composant électronique 20. En l'absence de contraintes mécaniques, le substrat 10, le composant électronique 20 et le film d'interconnexion 40 s'étendent selon des plans parallèles.

Le substrat 10 est avantageusement flexible (rayon de courbure inférieur ou égal à 1000 mm). De préférence, le substrat 10 peut subir sans rompre une flexion d'un rayon de courbure inférieur ou égal à 200 mm et plus préférentiellement encore inférieur ou égal à 50 mm. Un substrat 10 flexible confère de la souplesse à la structure électronique 2, ce qui lui permet d'être positionnée sur un support non plan ou sur une surface qui se déforme dans le temps, comme un corps en mouvement. La structure électronique 2 trouve ainsi de nombreuses applications dans le domaine médical en tant que patch porté par une personne, par exemple sur un poignet, un bras ou un torse.

A titre d'exemple, la structure électronique 2 peut faire partie d'un système de mesure de la température, de la fréquence cardiaque, de la pression artérielle ou du taux d'oxygène, d'un système d'actimétrie (mesure et analyse des mouvements), d'un système de mesure de la sécrétion de la peau (ex. sueur), d'un système de stimulation électrique ou optique, ou encore d'un système d'administration de médicament (aussi appelé patch transdermique).

La structure électronique 2 elle-même peut être qualifiée de flexible (ou souple) lorsqu'elle est capable de fléchir jusqu'à présenter un rayon de courbure inférieur ou égal à 1000 mm (de préférence inférieur ou égal à 200 mm et plus préférentiellement encore inférieur ou égal à 50 mm) sans subir de dommage.

Le substrat 10 comprend de préférence un film support 11 et au moins un plot électriquement conducteur 12 dit d'interconnexion disposé sur le film support 11 ou débouchant à la surface du film support 11. Il peut également comprendre un réseau d'interconnexions électriques relié au plot d'interconnexion 12 (ce réseau comprenant par exemple des pistes conductrices enterrées et des via reliant les pistes conductrices entre elles). Le substrat 10 peut être un circuit imprimé (ou PCB), un substrat flexible, un écran ou un autre composant électronique.

Dans la description qui suit, on considérera que le substrat 10 comprend une pluralité de plots d'interconnexion 12. Dans un souci de simplification, seuls deux plots d'interconnexion 12 ont été représentés dans le plan de coupe de la figure 5 (ce plan de coupe étant perpendiculaire aux plans du substrat 10, du composant électronique 20 et du film d'interconnexion 40).

Le film support 11 est avantageusement constitué d'un matériau souple, c'est-à-dire un matériau présentant un module de Young inférieur ou égal à 10 GPa, et de préférence inférieur ou égal 5 GPa. Le film support 11 est de préférence en un matériau polymère, par exemple un polyester tel que le polyéthylène naphtalate (ou PEN) ou le polytéréphtalate d'éthylène (PET), un polyimide (PI), le polytétrafluoroéthylène (PTFE), le polyétheréthercétone (PEEK), le polycarbonate (PC) ou le polyéther sulfone (PES).

Alternativement, le film support 11 est en un matériau rigide (> 50 GPa), par exemple en verre, en céramique, en silicium ou en métal. Le film support 11 peut toutefois présenter une épaisseur permettant au substrat 10 de remplir la condition de flexion sans rupture indiquée ci-dessus.

L'épaisseur du film support 11 est de préférence comprise entre 50 µm et 250 µm lorsqu'il est en un matériau souple (ex. matériau polymère) et inférieure à 1 mm lorsqu'il est en un matériau rigide tel que le verre ou le silicium.

Les plots d'interconnexion 12 peuvent être métalliques, par exemple en cuivre (Cu), argent (Ag), or (Au), aluminium (Al), tungstène (W), nickel (Ni), platine (Pt), titane (Ti) ou ruthénium (Ru). Ils peuvent être aussi en oxyde d'indium-étain (ou ITO pour « indium tin oxide » en anglais) ou en polymère conducteur comme le poly(3,4-éthylènedioxythiophène) nommé PEDOT. Ils peuvent être réalisés par dépôt et gravure d'une ou plusieurs couches de métal, par sérigraphie à partir d'une pâte ou encre chargée en particules métalliques ou par voie additive (jet de matière, impression 3D). Chaque plot d'interconnexion 12 peut être constitué d'une seule couche ou d'un empilement de plusieurs couches ayant des fonctions différentes (ex. couche d'accroche, couche de barrière de diffusion et couche de finition inerte). L'épaisseur des plots d'interconnexion 12 peut être comprise entre 50 nm et 5 µm, et de préférence entre 100 nm et 2 µm.

Le composant électronique 20 peut être un circuit intégré (par exemple un circuit intégré à application spécifique (ou ASIC, pour « application-specific integrated circuit » en anglais), un capteur (de température, de fréquence cardiaque...), un actionneur, un stimulateur, une microbatterie ou une puce RFID. Son épaisseur est avantageusement inférieure ou égale à 1 mm, de préférence inférieure ou égale à 100 µm, afin de maximiser les propriétés de souplesse de la structure électronique 2.

Le composant électronique 20 comprend au moins un plot de connexion 21 débouchant sur une face dite active du composant (autrement dit, une partie de la face active est formée par le plot de connexion 21). Le plot de connexion 21 est de préférence enrobé dans une couche diélectrique 22. Il forme avantageusement une surface plane avec la couche diélectrique 22. La couche diélectrique 22, aussi appelée couche de passivation, est constituée d'un matériau électriquement isolant.

Comme illustré sur la figure 5, le composant électronique 20 peut comprendre une pluralité de plots de connexion 21 distincts et contenus dans la couche diélectrique 22. Les plots de connexion 21 constituent typiquement les bornes d'entrée et de sortie du composant électronique 20.

Les plots de connexion 21 sont de préférence en métal, par exemple en cuivre (Cu), argent (Ag), or (Au), aluminium (Al), alliage d'aluminium de type AlSi ou AlCu, tungstène (W), nickel (Ni), platine (Pt), titane (Ti) ou ruthénium (Ru).

La face active du composant électronique 20 est tournée vers le substrat 10. Ainsi, le composant électronique 20 est interconnecté au substrat 10 selon une technique d'interconnexion de type « flip-chip ».

Au moins un élément métallique 43 du film d'interconnexion 40, appelé élément d'interconnexion électrique, assure la connexion électrique entre le composant électronique 20 et le substrat 10. Cet élément métallique 43 peut être agencé pour relier électriquement un plot d'interconnexion 12 du substrat 10 à un plot de connexion 21 du composant électronique 20.

De préférence, le film d'interconnexion 40 comprend plusieurs éléments d'interconnexion électrique.

Les deuxièmes motifs 432 améliorent la résistance des éléments d'interconnexion électrique aux contraintes mécaniques, en particulier aux contraintes de traction, cisaillement et/ou flexion.

Un ou plusieurs éléments métalliques 43 du film d'interconnexion 40 peuvent ne pas servir d'éléments d'interconnexion électrique entre le substrat 10 et le composant électronique 20.

Dans la configuration de la figure 5, la première face 41a de la couche de base 41 est disposée en regard du substrat 10 et la deuxième face 41b de la couche de base 41 est disposée en regard du composant électronique 20. Les premiers motifs 42 et les deuxièmes motifs 432 sont donc en contact avec le substrat 10.

La deuxième face 41b de la couche de base 41 est avantageusement collée au composant électronique 20. Autrement dit, une couche de colle 50 sépare le composant électronique 20 et la deuxième face 41b de la couche de base 41.

Dans une autre configuration non représentée par les figures, la première face 41a de la couche de base 41 est disposée en regard du composant électronique 20 et la deuxième face 41b de la couche de base 41 est disposée en regard du substrat 10. Les premiers motifs 42 et les deuxièmes motifs 432 sont donc en contact avec le composant électronique 20. La deuxième face 41b de la couche de base 41 peut être collée au substrat 10.

Pour que le film d'interconnexion 40 adhère au substrat 10 (respectivement au composant électronique 20) au moyen des premiers motifs 42 (adhésion sèche), on applique une pression sur la deuxième face 41b de la couche de base 41, par exemple par l'intermédiaire du composant électronique 20 (respectivement du substrat 10). Ce faisant, les premiers motifs 42 en polymère se déforment temporairement (élastiquement).

Le fait que les deuxièmes motifs 432 présentent une hauteur supérieure ou égale à celle des premiers motifs 42 garantit un contact électrique même après que les premiers motifs 42 ont retrouvé leur forme initiale. La compression des premiers motifs 42, et donc la différence de hauteur entre les premiers motifs 42 et les deuxièmes motifs 432, peut être comprise entre 1 µm et 2 µm.

La figure 6 montre que les deuxièmes motifs 432 des éléments métalliques 43 peuvent fléchir ou se déformer au contact du substrat 10, notamment lorsqu'ils présentent une hauteur supérieure à celle des premiers motifs 42, et ce même après que la pression a été relâchée.

Grâce au film d'interconnexion 40 constitué principalement du matériau polymère, la structure électronique 2 présente une excellente résistance aux contraintes mécaniques, en particulier aux contrainte de traction (étirement), de flexion et de cisaillement.

Outre les applications dans le domaine médical, le film d'interconnexion 40 peut être utilisé pour fonctionnaliser une surface, telle qu'un écran ou un tableau de bord. Il peut également faciliter le démontage d'un composant électronique ou servir au test de composant électronique sur une carte électronique.

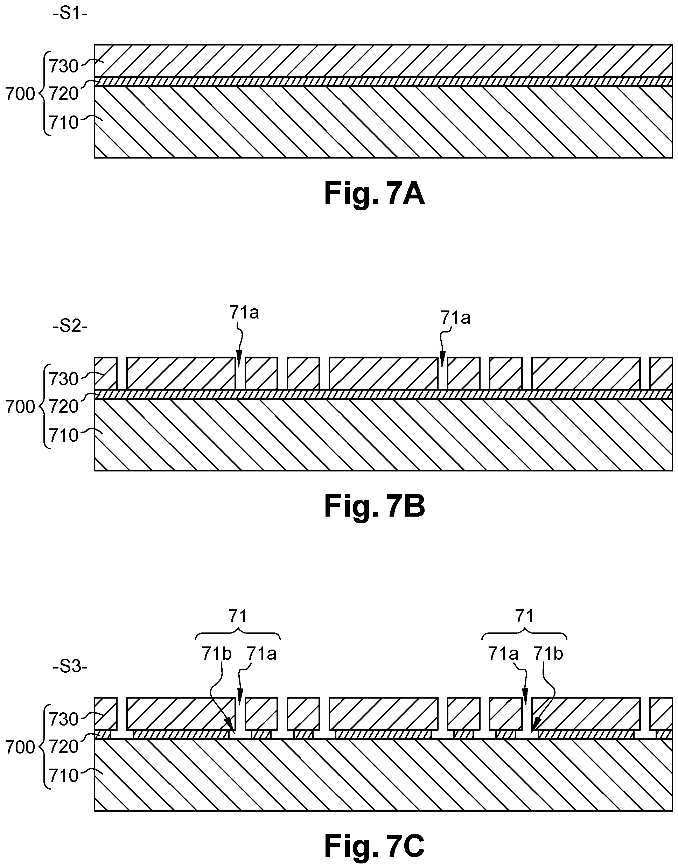

Les figures 7A à 7K représentent des étapes S1 à S10 d'un procédé de fabrication du film d'interconnexion 40 décrit ci-dessus.

Les étapes 7A à 7D sont relatives à la fourniture d'un moule 70 comprenant des premières cavités 71 destinées à la formation des premiers motifs 42 et au moins une deuxième cavité 72 destinée à la formation d'un deuxième motif 432. Ainsi, les premières cavités 71 ont la forme et les dimensions des premiers motifs 42 et la deuxième cavité 72 a la forme et les dimensions d'un deuxième motif 432. Les premières cavités 71 et la deuxième cavité 72 s'étendent depuis une face extérieure (ou face supérieure) 70a du moule 70, de préférence perpendiculairement au plan de cette face extérieure 70a.

Le procédé de fabrication sera décrit ci-après en prenant l'exemple d'un moule 70 comprenant plusieurs deuxièmes cavités 72 pour former plusieurs deuxièmes motifs 432 appartenant à une pluralité d'éléments métalliques 43.

Le moule 70 peut être fabriqué à partir d'un empilement 700, fourni à l'étape S1 de la figure 7A. L'empilement 700 comprend successivement une couche de support 710, une couche diélectrique 720 et une couche mince 730. La surface de la couche mince 730 constitue la face extérieure (ou face supérieure) 70a du moule 70.

La couche de support 710 est de préférence en un matériau semi-conducteur, par exemple en silicium.

La couche diélectrique 720 est de préférence une couche d'oxyde dite enterrée (ou couche BOX, pour « buried oxide layer » en anglais), par exemple en dioxyde de silicium (SiO₂). Son épaisseur est de préférence comprise entre 1 µm et 5 µm.

La couche mince 730 (aussi appelée couche active, couche de dispositif ou couche supérieure) est de préférence en un matériau semi-conducteur, par exemple en silicium monocristallin. Son épaisseur est de préférence inférieure ou égale à 30 µm, plus préférentiellement comprise entre 5 µm et 30 µm.

L'empilement 700 peut notamment être une structure multicouche de type silicium sur isolant ou SOI (« Silicon On Insulator » en anglais), communément appelée substrat SOI.

A l'étape S2 de la figure 7B, une première portion 71a des premières cavités 71 est formée en gravant la couche mince 730 jusqu'à la couche diélectrique 720. La gravure est accomplie à travers un premier masque de gravure (non représenté), par exemple en résine photosensible, formé préalablement sur la couche mince 730. La couche mince 730 est de préférence gravée de manière anisotrope, par exemple par gravure ionique réactive profonde (DRIE) ou par gravure ionique réactive au moyen d'un plasma à couplage inductif (RIE-ICP). La couche diélectrique 720 sert de couche d'arrêt à la gravure.

Puis, à l'étape S3 de la figure 7C, une deuxième portion 71b des premières cavités 71 est formée en gravant la couche diélectrique 720 sélectivement par rapport à la couche de support 710 et à la couche mince 730. Cette gravure est de préférence une gravure isotrope, par exemple une gravure humide dans un bain ou vapeur d'acide fluorhydrique (HF) dans le cas d'une couche diélectrique 720 en SiO₂.

La première portion 71a des premières cavités 71 située dans la couche mince 730 est destinée à former le pilier 421 des premiers motifs 42, tandis que la deuxième portion 71b des premières cavités 71 située dans la couche diélectrique 720 est destinée à former le chapeau 422 des premiers motifs 42.

Le premier masque de gravure peut être retiré après l'étape de gravure S2 de la figure 7B ou après l'étape de gravure S3 de la figure 7C.

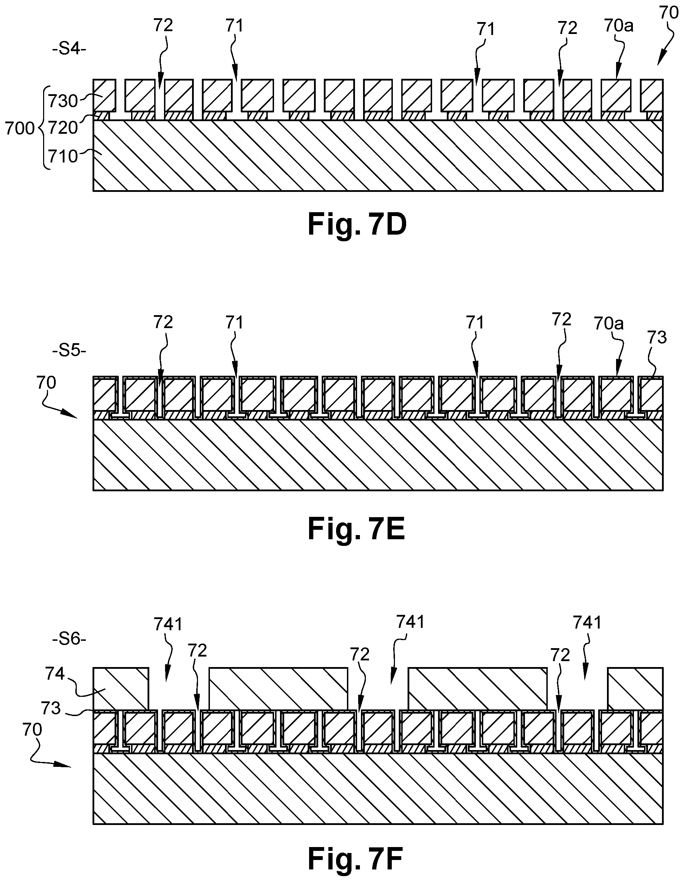

La figure 7D représente une étape S4 de formation des deuxièmes cavités 72 du moule 70, ici par gravure d'au moins la couche mince 730 et la couche diélectrique 720. Cette gravure est accomplie à travers un deuxième masque de gravure (non représenté), formé préalablement sur la couche mince 730. Le deuxième masque de gravure est de préférence constitué d'une résine photosensible en film sec, pour éviter de remplir les premières cavités 71 du moule 70.

Dans un premier mode de mise en oeuvre, l'étape S4 de formation des deuxièmes cavités 72 comprend deux opérations de gravure successives (à travers le deuxième masque de gravure) :
- gravure anisotrope (ex. par DRIE ou RIE-ICP) de la couche mince 730, avec arrêt sur la couche diélectrique 720 ; et
- gravure anisotrope (ex. par RIE) de la couche diélectrique 720 avec arrêt sur la couche de support 710.

Les deuxièmes cavités 72 présentent alors une profondeur égale à celle des premières cavités 71 (et égale à la somme des épaisseurs de la couche mince 730 et de la couche diélectrique 720).

Dans un deuxième mode de mise en oeuvre, l'étape S4 de formation des deuxièmes cavités 72 comprend trois opérations de gravure successives (à travers le deuxième masque de gravure) :
- gravure anisotrope (ex. par DRIE ou RIE-ICP) de la couche mince 730, avec arrêt sur la couche diélectrique 720 ;
- gravure anisotrope (ex. par RIE) de la couche diélectrique 720 avec arrêt sur la couche de support 710 ; et
- gravure anisotrope d'une partie superficielle de la couche de support 710 (typiquement sur une profondeur comprise entre 1 µm et 2 µm).

Le deuxième masque de gravure est retiré après l'étape S4 de formation des deuxièmes cavités 72.

L'étape S4 de formation des deuxièmes cavités 72 (cf. Fig.7D) peut être accomplie avant les étapes S2 et S3 de formation des premières cavités 71 (cf. Figs.7B-7C).

Les étapes S5 à S8 représentées par les figures 7E à 7H sont relatives à la formation des éléments métalliques 43 du film d'interconnexion 40.

En S5 (cf. Fig.7E), une couche métallique de germination 73 est déposée dans les premières cavités 71, dans les deuxièmes cavités 72 et sur la face extérieure 70a du moule 70. La couche métallique de germination 73 est déposée par une technique de dépôt conforme, telle que le dépôt chimique en phase vapeur (ou CVD, pour « Chemical Vapor Déposition » en anglais). Elle recouvre ainsi les parois des premières et deuxièmes cavités 71-72, sans les remplir entièrement, et la face extérieure 70a du moule. La couche métallique de germination 73 est par exemple constituée d'un alliage de titane et de cuivre (TiCu), d'un alliage de titane, de nitrure de titane et de cuivre (TiTiNCu), d'un alliage de titane, de nickel et d'or (TiNiAu) ou d'un alliage de titane, de nitrure de titane et d'or (TiTiNAu).

Puis, en S6 (cf. Fig.7F), un masque 74 est formé sur la couche métallique de germination 73. Le masque 74 comprend des évidements 741, chaque évidemment 741 exposant une région du moule 70 dédiée à la formation d'un élément métallique 43 du film d'interconnexion 40. Chaque région du moule 70 dédiée à la formation d'un élément métallique 43 comprend une ou plusieurs deuxièmes cavités 72 (parmi la pluralité de deuxièmes cavités 72 du moule). Le masque 74 est de préférence constitué d'une résine photosensible en film sec, pour éviter de remplir les premières et deuxièmes cavités 71-72 du moule 70 (lors de sa formation).

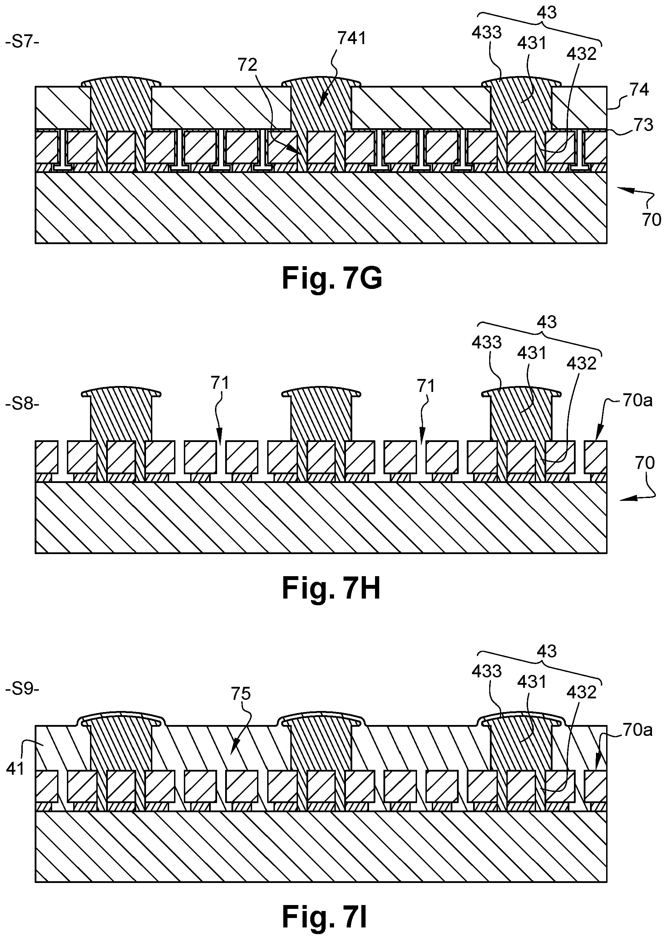

Lors d'une étape S7 représentée par la figure 7G, les deuxièmes cavités 72 du moule 70 et les évidements 741 du masque 74 sont remplis d'un métal par croissance électrolytique depuis la couche de germination 73. On forme ainsi les deuxièmes motifs 432 des éléments métalliques 43 à l'intérieur des deuxièmes cavités 72 et le corps 431 des éléments métalliques 43 dans les évidements 741 du masque 74, sur la surface extérieure 70a du moule 70. La croissance peut se poursuivre après le remplissage complet des évidements 741 de manière à former les têtes 433 des éléments métalliques 43 (le métal débordant sur le masque 74).

En S8 (cf. Fig.7H), le masque 74 est retiré puis la couche métallique de germination 73 est gravée (en dehors des régions occupées par les éléments métalliques 43).

A l'étape S9 de la figure 7I, un matériau polymère électriquement isolant 75 est déposé dans les premières cavités 71 et sur la face extérieure 70a du moule 70, de manière à former un film de polymère qui remplit les premières cavités 71 et enrobe le corps 431 des éléments métalliques 43. Le matériau polymère, initialement sous forme liquide, est déposé (coulé) sur le moule 70, dans les premières cavités 71 et autour des éléments métalliques 43, puis durci ou réticulé (dans des conditions propres à chaque matériau polymère).

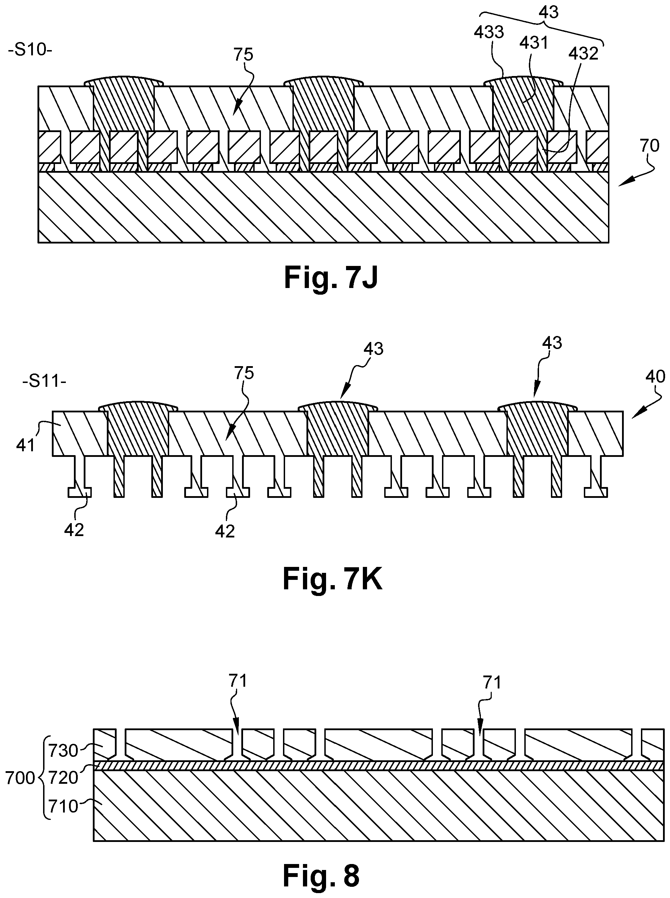

Le matériau polymère 75 peut être déposé en excès et recouvrir complètement les éléments métalliques 43. La face supérieure des éléments métalliques 43 est alors mise à nue lors d'une étape S10 représentée par la figure 7J, par exemple par polissage mécano-chimique ou gravure du polymère (par exemple par RIE).

Enfin, à l'étape S11 de la figure 7K, le film de polymère et les éléments métalliques 43 prisonniers du film de polymère sont extraits du moule 70. L'ensemble obtenu à l'issue de cette étape S11 de démoulage constitue le film d'interconnexion 40. Le film de polymère forme la couche de base 41 et les premiers motifs 42 du film d'interconnexion 40. Les premiers motifs 42 se démoulent facilement car ils sont en matériau polymère. Les deuxièmes motifs 432 des éléments métalliques 43 se démoulent tout aussi facilement malgré leur rigidité, grâce à leur géométrie particulière (différente de celle des premiers motifs 42).

Pour obtenir un film d'interconnexion 40 dont les deux faces sont structurées, deux films tels que représentés par la figure 7K peuvent être fabriqués puis couplés entre eux (au niveau de leur face non-structurée), par exemple par activation de surface de type plasma puis assemblage par pression.

La figure 8 représente une variante de mise en oeuvre de l'étape de formation des premières cavités 71 du moule 70. Plutôt que graver successivement la couche mince 730 (étape S2) et la couche diélectrique 720 (étape S3), les premières cavités 71 sont obtenues en gravant uniquement la couche mince 730, d'abord de manière anisotrope (ex. DRIE ou RIE-ICP) avec un arrêt sur la couche diélectrique 720, puis en effectuant une sur-gravure de la couche mince 730 (c'est-à-dire qu'on poursuit la gravure sélective de sorte à graver latéralement la couche mince 730, le long de la couche diélectrique 720). On obtient alors des premières cavités 71 de forme évasée, permettant d'obtenir les premiers motifs 42 de la figure 4. Les dimensions latérales de cet évasement (et donc du chapeau 422) dépendent de temps de sur-gravure (compté à partir du moment où la gravure atteint la couche diélectrique 720). Par exemple, le diamètre de la zone surgravée à l'interface avec la couche diélectrique 720 peut être de 15 µm pour une cavité de départ de 10 µm de diamètre (dans la partie supérieure de la couche mince 730).

Les deuxièmes cavités 72 peuvent être alors obtenues soit en gravant (de manière anisotrope) uniquement la couche mince 730 jusqu'à la couche diélectrique 720 (même profondeur que les premières cavités 71), soit en gravant successivement la couche mince 730 et la couche diélectrique 720 (deuxièmes cavités 72 plus profondes que les premières cavités 71), comme décrit précédemment en relation avec la figure 7D (premier mode de mise en oeuvre).

De nombreuses variantes et modifications du film d'interconnexion, de son procédé de fabrication et de la structure électronique apparaîtront à l'homme du métier. En particulier, le substrat 10 de la structure électronique 2 peut ne pas être flexible. Dans ce cas, le film d'interconnexion 40 est avantageux pour absorber des contraintes mécaniques dues à la différence des coefficients de dilatation thermique entre le substrat 10 et le composant électronique 20.

## Revendications

1. Film d'interconnexion (40) comprenant :
- une couche de base (41) formée d'un matériau polymère électriquement isolant et comprenant une première face (41a) et une deuxième face (41b) opposée à la première face ;
- une pluralité de premiers motifs (42) en saillie par rapport à la première face (41a), les premiers motifs étant formés du matériau polymère électriquement isolant et configurés pour que le film d'interconnexion (40) constitue un film d'adhésif sec ;
- un élément métallique (43) comprenant :
∘ un corps (431) qui s'étend à travers la couche de base (41), de la première face (41a) à la deuxième face (41b) ; et
∘ dans le prolongement du corps (431), au moins un deuxième motif (432) en saillie par rapport à la première face ;
**caractérisé en ce que** l'élément métallique (43) est en métal massif et **en ce que** ledit au moins un deuxième motif (432) de l'élément métallique (43) présente une forme différente de celle des premiers motifs (42) et, dans un plan parallèle à la première face (41a), une section constante ou décroissante en s'éloignant de la première face.

2. Film d'interconnexion (40) selon la revendication 1, dans lequel chaque premier motif (42) comprend un pilier (421) qui s'étend depuis la première face (41a) de la couche de base (41) et un chapeau (422) situé à une extrémité du pilier, le chapeau ayant, dans un plan parallèle à la première face, des dimensions supérieures à celles du pilier.

3. Film d'interconnexion (40) selon l'une des revendications 1 et 2, dans lequel l'élément métallique (43) comprend en outre, dans le prolongement du corps (431), une tête (433) qui repose sur la deuxième face (41b) de la couche de base (41).

4. Film d'interconnexion (40) selon l'une quelconque des revendications 1 à 3, dans lequel ledit au moins un deuxième motif (432) de l'élément métallique (43) présente une hauteur supérieure ou égale à celle des premiers motifs (42).

5. Structure électronique (2) comprenant :
- un substrat (10) ;
- un composant électronique (20) ;
- un film d'interconnexion (40) selon l'une quelconque des revendications 1 à 4, disposé entre le substrat (10) et le composant électronique (20) de manière à relier électriquement et mécaniquement le composant électronique au substrat.

6. Structure électronique (2) selon la revendication 5, dans lequel :
- le substrat (10) comprend un plot électriquement conducteur (12) ;
- le composant électronique (20) comprend un plot de connexion (21) ; et
- l'élément métallique (43) du film d'interconnexion (40) relie le plot électriquement conducteur (12) au plot de connexion (21).

7. Structure électronique (2) selon l'une des revendications 5 et 6, dans lequel :
- la première face (41a) de la couche de base (41) est disposée en regard du substrat (10) ;
- les premiers motifs (42) sont en contact avec le substrat (10) ; et
- la deuxième face (41b) de la couche de base est disposée en regard du composant électronique (20).

8. Structure électronique (2) selon la revendication 7, dans lequel la deuxième face (41b) de la couche de base (41) est séparée du composant électronique (20) par une couche de colle (50).

9. Procédé de fabrication d'un film d'interconnexion (40), comprenant les étapes suivantes :
- fournir (S1-S4) un moule (70) comprenant des premières cavités (71) et une deuxième cavité (72), les premières cavités et la deuxième cavité s'étendant depuis une face extérieure (70a) du moule, la deuxième cavité (72) ayant une forme différente de celle des premières cavités (71) et, dans un plan parallèle à la face extérieure (70a), une section constante ou décroissante en s'éloignant de la face extérieure ;
- former (S5-S8) un élément métallique (73) dans une région du moule (70) comprenant la deuxième cavité (72), l'élément métallique comprenant un corps (431) disposé sur la face extérieure (70a) du moule et, dans le prolongement du corps, un motif en saillie (432) disposé à l'intérieur de la deuxième cavité (72) ;
- déposer (S9) un matériau polymère électriquement isolant (75) dans les premières cavités (71) et sur la face extérieure (70a) du moule (70), de manière à former un film de polymère qui enrobe le corps (431) de l'élément métallique (43) ; et
- démouler (S11) le film de polymère et l'élément métallique (43).

10. Procédé selon la revendication 9, dans lequel l'étape de formation de l'élément métallique (43) comprend les sous-étapes suivantes :
- déposer (S5) une couche métallique de germination (73) dans la deuxième cavité (72) et sur la face extérieure (70a) du moule (70) ;
- former (S6) un masque (74) sur la couche métallique de germination (73), le masque comprenant un évidement (741) qui expose ladite région du moule (70) comprenant la deuxième cavité (72) ;
- remplir (S7) la deuxième cavité (72) du moule (70) et l'évidement (741) du masque (74) d'un métal par croissance électrolytique depuis la couche de germination (73) ; et
- retirer (S8) le masque (74) et graver la couche métallique de germination (73).

11. Procédé selon l'une des revendications 9 et 10, dans lequel l'étape de fourniture du moule (70) comprend les sous-étapes suivantes :
- fournir (S1) un empilement (700) comprenant successivement une couche de support (710), une couche diélectrique (720) et une couche mince (730) ;
- former les premières cavités (71) en gravant (S2) la couche mince (730) jusqu'à la couche diélectrique (720), puis (S3) en gravant la couche diélectrique (720) sélectivement par rapport à la couche mince (730) et la couche de support (710) ; et
- former (S4) la deuxième cavité (72) en gravant au moins la couche mince (730) et la couche diélectrique (720).

12. Procédé selon l'une des revendications 9 et 10, dans lequel l'étape de fourniture du moule (70) comprend les sous-étapes suivantes :
- fournir (S1) un empilement (700) comprenant successivement une couche de support (710), une couche diélectrique (720) et une couche mince (730) ;
- former les premières cavités (71) en gravant de manière anisotrope la couche mince (730) jusqu'à la couche diélectrique (720), puis en effectuant une sur-gravure de la couche mince (730) ; et
- former la deuxième cavité (72) en gravant au moins la couche mince (730) jusqu'à la couche diélectrique (720).
